# EUROPEAN PATENT APPLICATION

(11) **EP 4 716 433 A1**
(43) Date of publication of application: **25.03.2026**
(21) Application number: 24926869.9
(22) Date of filing: 04.12.2024
(51) Int. Cl.: H10K 30/87, H10K 39/15, H10K 71/00

(54) **TWO-TERMINAL PEROVSKITE-SILICON TANDEM SOLAR CELL AND PREPARATION METHOD THEREFOR**

(30) Priority: 29.02.2024 CN 202410232818
(71) Applicant: CHINT New Energy Technology Co., Ltd., Haining, Zhejiang 314400 (CN)
(72) Inventor: LI, Zijia, Jiaxing, Zhejiang 314400 (CN); JIA, Zhen, Jiaxing, Zhejiang 314400 (CN); LI, Xiaowei, Jiaxing, Zhejiang 314400 (CN); WANG, Shumao, Jiaxing, Zhejiang 314400 (CN); CHEN, Koucheng, Jiaxing, Zhejiang 314400 (CN); WANG, Yong, Jiaxing, Zhejiang 314400 (CN); JIN, Tong, Jiaxing, Zhejiang 314400 (CN)
(74) Representative: PGA S.p.A., Milano, Succursale di Lugano
(86) International application number: PCT/CN2024/136732
(87) International publication number: WO 2025/180011

(57) **Abstract**

A two-terminal perovskite-silicon tandem solar cell and a preparation method therefor, which are applied to the technical field of perovskite solar cells. The two-terminal perovskite-silicon tandem solar cell comprises a perovskite-silicon tandem solar cell and a near-infrared-light conversion layer, wherein the perovskite-silicon tandem solar cell comprises a tandem solar cell sheet, which comprises a perovskite solar cell structure used for absorbing visible light, and a crystalline silicon solar cell structure used for absorbing near-infrared light; and the near-infrared-light conversion layer is arranged on the surface of a light-incident side of the perovskite-silicon tandem solar cell, and is a down-conversion thin film. Short-wavelength sunlight is converted into long-wavelength light by means of the near-infrared-light conversion layer, so as to solve the problem of current mismatch in a two-terminal perovskite-silicon tandem solar cell caused by illumination conditions with a high visible-light proportion, such that the two-terminal perovskite-silicon tandem solar cell has relatively high performance.

## Description

This application claims the priority of Chinese Patent Application No. 202410232818.X, filed with the China National Intellectual Property Administration on February 29, 2024, and titled with "TWO-TERMINAL PEROVSKITE-SILICON TANDEM SOLAR CELL AND PREPARATION METHOD THEREFOR", which is hereby incorporated by reference in its entirety.

### FIELD

The present disclosure relates to the technical field of perovskite solar cells, in particular to a two-terminal perovskite-crystalline silicon tandem solar cell and a production method therefor.

### BACKGROUND

A two-terminal perovskite-crystalline silicon tandem solar cell consists of a perovskite solar cell as a top cell for absorbing visible light and a crystalline silicon solar cell as a bottom cell for absorbing near-infrared light. This tandem solar cell has a tandem structure, and a current thereof is determined by the lowest value among currents of all sub-cells. In order to achieve current matching so as to maximize the conversion efficiency, reasonable absorption spectrum allocation needs to be performed on the sub-cells. Since the bandgap of the crystalline silicon solar cell is fixed, in order to achieve maximized utilization of an AM1.5 standard solar spectrum, it is necessary to control the bandgap of the perovskite bottom cell within a range of 1.68 eV to 1.72 eV, and it is also necessary to optimize thicknesses of respective layers to achieve current matching.

However, the optimized structure of the above-mentioned two-terminal perovskite-crystalline silicon tandem solar cell (including the bandgap of perovskite and the thickness of perovskite) is entirely based on the AM1.5 standard solar spectrum. AM refers to air mass, and AM1.5 refers to light incident on the earth's surface when the air mass is 1.5. However, when the air mass is different, for example due to differences in latitude, weather, climate, and the like, a solar spectrum will be different from the AM1.5 standard solar spectrum. A literature points out that the proportion of short wavelengths in the solar spectrum at sunrise is significantly lower than the proportion of short wavelengths at noon. At this time, the two-terminal perovskite-crystalline silicon tandem solar cell optimized based on the AM1.5 standard solar spectrum will no longer be an optimal structure, and the bandgap and thickness of the perovskite and even the tandem structure need to be readjusted. That is, the solar spectrum varies according to differences in regions and times. Alternatively, when the two-terminal perovskite-crystalline silicon tandem solar cell is located indoors, the proportion of visible light from an indoor light source is higher than that of outdoor sunlight, which will cause the current generated by the crystalline silicon bottom cell to be relatively small. Therefore, when the two-terminal perovskite-crystalline silicon tandem solar cell optimized based on AM1.5 is under non-AM1.5 illumination, the cell will exhibit current mismatch and low efficiency, which is unfavorable for future standardized production and large-scale commercialization of two-terminal perovskite-crystalline silicon tandem solar cells.

Therefore, how to provide a two-terminal perovskite-crystalline silicon tandem solar cell that can possess relatively high performance under non-AM1.5 standard solar spectrum conditions is an urgent problem to be solved by those skilled in the art.

### SUMMARY

A purpose of the present disclosure is to provide a two-terminal perovskite-crystalline silicon tandem solar cell, which still possesses relatively high performance under non-AM1.5 standard solar spectrum conditions. Another purpose of the present disclosure is to provide a method for producing a two-terminal perovskite-crystalline silicon tandem solar cell, wherein the produced two-terminal perovskite-crystalline silicon tandem solar cell still possesses relatively high performance under non-AM1.5 standard solar spectrum conditions.

To solve the above technical problems, the present disclosure provides a two-terminal perovskite-crystalline silicon tandem solar cell, comprising a perovskite-crystalline silicon tandem solar cell and a near-infrared light conversion layer; wherein:
the perovskite-crystalline silicon tandem solar cell comprises a tandem solar cell sheet, and the tandem solar cell sheet comprises a perovskite solar cell structure for absorbing visible light and a crystalline silicon solar cell structure for absorbing near-infrared light; and
the near-infrared light conversion layer is provided on a surface of light-incident side of the perovskite-crystalline silicon tandem solar cell, and the near-infrared light conversion layer is a down-conversion film.

Optionally, the perovskite-crystalline silicon tandem solar cell comprises a back plate and a transparent cover plate disposed opposite to each other, the tandem solar cell sheet is encapsulated between the back plate and the transparent cover plate by an encapsulation material, and the near-infrared light conversion layer is provided on a surface of the transparent cover plate facing away from the back plate.

Optionally, the near-infrared light conversion layer is detachably connected to the surface of the transparent cover plate facing away from the back plate.

Optionally, the near-infrared light conversion layer comprises a polymer matrix and a near-infrared luminescent material dispersed in the polymer matrix; and the near-infrared luminescent material is a down-conversion luminescent material.

Optionally, the near-infrared luminescent material comprises any one or a combination of:
a near-infrared quantum-dot material and a near-infrared phosphor material.

Optionally, the near-infrared luminescent material has an absorption peak located in a range of 300 nm to 800 nm, and an emission peak located in a range of 800 nm to 1100 nm..

Optionally, the polymer matrix is at least one selected from the group consisting of:
polyolefin elastomer, polymethyl methacrylate, polyvinylpyrrolidone, silicone, and acrylic resin.

The present disclosure further provides a method for producing a two-terminal perovskite-crystalline silicon tandem solar cell, comprising:
producing a near-infrared light conversion layer; wherein the near-infrared light conversion layer is a down-conversion film;
producing a perovskite-crystalline silicon tandem solar cell; wherein the perovskite-crystalline silicon tandem solar cell comprises a tandem solar cell sheet, and the tandem solar cell sheet comprises a perovskite solar cell structure for absorbing visible light and a crystalline silicon solar cell structure for absorbing near-infrared light; and
providing the near-infrared light conversion layer on a surface of light-incident side of the perovskite-crystalline silicon tandem solar cell to produce the two-terminal perovskite-crystalline silicon tandem solar cell.

Optionally, the producing a near-infrared light conversion layer comprises:
producing a near-infrared luminescent material; wherein the near-infrared luminescent material is a down-conversion luminescent material;
adding the near-infrared luminescent material into a polymer melt to produce a wet film; and
curing the wet film to produce the near-infrared light conversion layer.

Optionally, the producing a perovskite-crystalline silicon tandem solar cell comprises:
providing amorphous silicon layers on opposite surfaces of an N-type silicon substrate;
providing a P-type amorphous silicon layer on a surface of the amorphous silicon layer on one side, and providing an N-type amorphous silicon layer on a surface of the amorphous silicon layer on the other side;
providing conductive layers on both surfaces of the P-type amorphous silicon layer and the N-type amorphous silicon layer;
providing a hole transport layer on a surface of the conductive layer provided on the surface of P-type amorphous silicon layer;
sequentially providing a perovskite light-absorbing layer, an electron transport layer, and an electrode on a surface of the hole transport layer along a thickness direction to produce the tandem solar cell sheet; and
encapsulating the tandem solar cell sheet between a back plate and a transparent cover plate by an encapsulation material to produce the perovskite-crystalline silicon tandem solar cell.

The two-terminal perovskite-crystalline silicon tandem solar cell provided by the present disclosure comprises a perovskite-crystalline silicon tandem solar cell and a near-infrared light conversion layer; the perovskite-crystalline silicon tandem solar cell comprises a tandem solar cell sheet, and the tandem solar cell sheet comprises a perovskite solar cell structure for absorbing visible light and a crystalline silicon solar cell structure for absorbing near-infrared light; and the near-infrared light conversion layer is provided on a surface of light-incident side of the perovskite-crystalline silicon tandem solar cell, wherein the near-infrared light conversion layer is a down-conversion film.

By providing the near-infrared light conversion layer, short wavelengths in sunlight are converted into long wavelengths, corresponding to absorption by the perovskite top cell and by the crystalline silicon bottom cell respectively, so as to solve the problem of current mismatch caused by the two-terminal perovskite-crystalline silicon tandem solar cell being under lighting conditions with a relatively high proportion of visible light, thereby enabling the two-terminal perovskite-crystalline silicon tandem solar cell to possess relatively high performance.

The present disclosure further provides a method for producing a two-terminal perovskite-crystalline silicon tandem solar cell, which also possesses the above-mentioned beneficial effects, and the details are not repeated herein.

### BRIEF DESCRIPTION OF DRAWINGS

To more clearly describe the technical solutions in the examples of the present disclosure or in the prior art, the following briefly introduces the drawings required for describing the examples or the prior art. Apparently, the drawings in the following description are merely some embodiments of the present disclosure, and a person of ordinary skill in the art may still obtain other drawings from these drawings without making inventive efforts.
FIG. 1 is a structural schematic diagram of a two-terminal perovskite-crystalline silicon tandem solar cell provided by an example of the present disclosure;
FIG. 2 is a process flow chart of a method for producing a two-terminal perovskite-crystalline silicon tandem solar cell provided by an example of the present disclosure;
FIG. 3 is a process flow chart of a method for producing a perovskite-crystalline silicon tandem solar cell provided by an example of the present disclosure;
FIG. 4 is an emission spectrum of CuInS₂/ZnS quantum-dot light conversion films produced based on different reaction times;
FIG. 5 is an emission spectrum of a near-infrared light conversion layer;
FIG. 6 is a diagram showing changes in current of a two-terminal perovskite-crystalline silicon tandem solar cell optimized based on AM1.5 standard sunlight in Comparative Example 1 as the test light spectrum changes;
FIG. 7 is a diagram showing changes in current of the two-terminal perovskite-crystalline silicon tandem solar cell 1 containing the near-infrared light conversion layer 2 in Example 1 as the test light spectrum changes.

In the figures: 1. perovskite-crystalline silicon tandem solar cell; 11. tandem solar cell sheet; 12. back plate; 13. transparent cover plate; 14. encapsulation material; 2. near-infrared light conversion layer.

### DETAILED DESCRIPTION

The core of the present disclosure is to provide a two-terminal perovskite-crystalline silicon tandem solar cell. In the prior art, optimized structures of two-terminal perovskite-crystalline silicon tandem solar cells are all based on AM1.5 standard sunlight. When a two-terminal perovskite-crystalline silicon tandem solar cell optimized based on AM1.5 is under non-AM1.5 illumination, the cell will exhibit current mismatch and low efficiency, which is unfavorable for future standardized production and large-scale commercialization of two-terminal perovskite-crystalline silicon tandem solar cells.

However, a two-terminal perovskite-crystalline silicon tandem solar cell provided by the present disclosure comprises a perovskite-crystalline silicon tandem solar cell and a near-infrared light conversion layer; the perovskite-crystalline silicon tandem solar cell comprises a tandem solar cell sheet, and the tandem solar cell sheet comprises a perovskite solar cell structure for absorbing visible light and a crystalline silicon solar cell structure for absorbing near-infrared light; and the near-infrared light conversion layer is provided on a surface of light-incident side of the perovskite-crystalline silicon tandem solar cell, wherein the near-infrared light conversion layer is a down-conversion film.

By providing the near-infrared light conversion layer, short wavelengths in sunlight are converted into long wavelengths, respectively corresponding to absorption by the perovskite top cell and by the crystalline silicon bottom cell, so as to solve the problem of current mismatch caused by the two-terminal perovskite-crystalline silicon tandem solar cell being under illumination conditions with a relatively high proportion of visible light, thereby enabling the two-terminal perovskite-crystalline silicon tandem solar cell to possess relatively high performance.

In order to enable those skilled in the art to better understand technical solutions of the present disclosure, the present disclosure is further described in detail below in conjunction with accompanying drawings and specific embodiments. Apparently, the described examples are merely some embodiments of the present disclosure, rather than all embodiments. Based on the embodiments in the present disclosure, all other embodiments obtained by a person of ordinary skill in the art without making inventive efforts shall fall within the protection scope of the present disclosure.

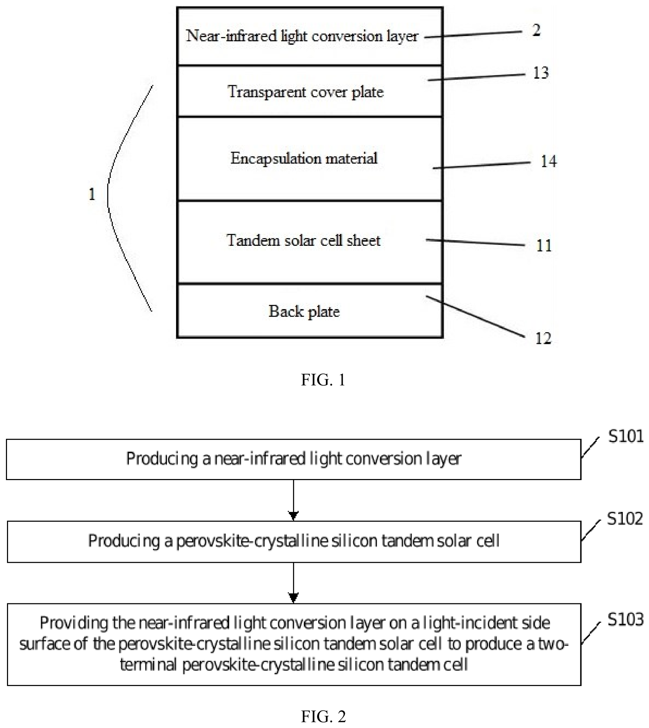

See FIG. 1, which is a structural schematic diagram of a two-terminal perovskite-crystalline silicon tandem solar cell provided by an example of the present disclosure.

As shown in FIG. 1, in an example of the present disclosure, the two-terminal perovskite-crystalline silicon tandem solar cell comprises a perovskite-crystalline silicon tandem solar cell 1 and a near-infrared light conversion layer 2; the perovskite-crystalline silicon tandem solar cell 1 comprises a tandem solar cell sheet 11, and the tandem solar cell sheet 11 comprises a perovskite solar cell structure for absorbing visible light and a crystalline silicon solar cell structure for absorbing near-infrared light. In this example, the perovskite solar cell structure and the crystalline silicon solar cell structure are usually current-matched based on AM1.5 standard sunlight; and the near-infrared light conversion layer 2 is provided on a surface of light-incident side of the perovskite-crystalline silicon tandem solar cell 1, wherein the near-infrared light conversion layer 2 is a down-conversion film.

The above-mentioned perovskite-crystalline silicon tandem solar cell 1 is a conventional tandem solar cell module. A core of the perovskite-crystalline silicon tandem solar cell 1 is the tandem solar cell sheet 11. The tandem solar cell sheet 11 comprises the perovskite solar cell structure for absorbing visible light and the crystalline silicon solar cell structure for absorbing near-infrared light, wherein the perovskite solar cell structure typically serves as a top cell of the tandem solar cell sheet 11, while the crystalline silicon solar cell structure serves as a bottom cell of the tandem solar cell sheet 11, absorbing light of corresponding wavelengths. For a specific structure of the tandem solar cell sheet 11, reference may be made to the prior art, and details are not repeated herein. In this example, the perovskite solar cell structure and the crystalline silicon solar cell structure of the tandem solar cell sheet 11 are usually current-matched based on AM1.5 standard sunlight; that is, the perovskite solar cell structure and the crystalline silicon solar cell structure generate a maximum current under AM1.5 standard sunlight illumination, and the tandem solar cell sheet 11 has a maximum power generation efficiency. Certainly, in this example, current matching of the perovskite solar cell structure and the crystalline silicon solar cell structure may also be performed based on other illumination conditions, and specific illumination conditions are not specifically limited herein; it is only required that external light, after passing through the near-infrared light conversion layer 2 described later, approximates the illumination conditions as much as possible, so as to maintain high power generation efficiency of the two-terminal perovskite-crystalline silicon tandem solar cell.

Specifically, in this example, the perovskite-crystalline silicon tandem solar cell 1 comprises a back plate 12 and a transparent cover plate 13 disposed opposite to each other, the tandem solar cell sheet 11 is encapsulated between the back plate 12 and the transparent cover plate 13 by an encapsulation material 14, and the near-infrared light conversion layer 2 is provided on a surface of the transparent cover plate 13 facing away from the back plate 12.

The above-mentioned back plate 12 may be a transparent back plate 12 or a non-transparent back plate 12. For the perovskite-crystalline silicon tandem solar cell 1, a double-glass encapsulation structure is usually used for encapsulation; therefore, the back plate 12 is usually a transparent back plate 12, which is usually glass. Correspondingly, glass is usually also used for the above-mentioned transparent cover plate 13 as a front cover plate. Certainly, in this example, specific materials of the back plate 12 and the transparent cover plate 13 are not specifically limited, and depend on specific circumstances. The above-mentioned encapsulation material 14 is usually polyolefin elastomer and butyl rubber, used for encapsulating the above-mentioned tandem solar cell sheet 11 between the back plate 12 and the transparent cover plate 13. For the perovskite-crystalline silicon tandem solar cell 1, the surface of the transparent cover plate 13 facing away from the back plate 12 is a light-incident surface, so the near-infrared light conversion layer 2 is provided on this surface.

It can be seen from the above structure that the perovskite-crystalline silicon tandem solar cell 1 in this example may be a perovskite-crystalline silicon tandem solar cell 1 with current matching performed using the most common AM1.5 standard sunlight as a standard. This structure is very conducive to standardized production and large-scale commercialization of the two-terminal perovskite-crystalline silicon tandem solar cell 1. The above-mentioned near-infrared light conversion layer 2 serves to make it more suitable for a lighting environment with a higher proportion of visible light than AM1.5 standard sunlight on the basis of the perovskite-crystalline silicon tandem solar cell 1.

The above-mentioned near-infrared light conversion layer 2 is provided on a surface of light-incident side of the perovskite-crystalline silicon tandem solar cell 1; that is, external natural light enters the near-infrared light conversion layer 2 first, and then enters the perovskite-crystalline silicon tandem solar cell 1. When natural light enters the near-infrared light conversion layer 2, the near-infrared light conversion layer 2 redistributes the proportion of light of each wavelength. Since the near-infrared light conversion layer 2 is a down-conversion film in this example, it absorbs short-wavelength light and releases long-wavelength light; that is, the near-infrared light conversion layer 2 converts visible light into near-infrared light, thereby adjusting the ratio of light of different wavelengths in the incident light. The two-terminal perovskite-crystalline silicon tandem solar cell of this example mainly operates in a lighting environment where a proportion of visible light is higher than that of AM1.5 standard sunlight. In such a lighting environment, when natural light transmits through the near-infrared light conversion layer 2 to the perovskite-crystalline silicon tandem solar cell 1, the light received by the perovskite-crystalline silicon tandem solar cell 1 is closer to AM1.5 standard sunlight compared with the current lighting environment. In other words, the near-infrared light conversion layer 2 adjusts the above-mentioned lighting environment to a lighting environment closer to AM1.5 standard sunlight, so that the perovskite-crystalline silicon tandem solar cell 1 possesses relatively high operating efficiency.

Specifically, in this example, the near-infrared light conversion layer 2 comprises a polymer matrix and a near-infrared luminescent material dispersed in the polymer matrix; the near-infrared luminescent material is a down-conversion luminescent material to form a down-conversion film. The above-mentioned near-infrared luminescent material comprises any one or a combination of: a near-infrared quantum-dot material and a near-infrared phosphor material. Correspondingly, in this example, the polymer matrix is at least one selected from the group consisting of: polyolefin elastomer, polymethyl methacrylate, polyvinylpyrrolidone, silicone, and acrylic resin. Certainly, in this example, specific structures or components of the near-infrared luminescent material and specific components of the polymer matrix are not specifically limited, and reference may be made to the prior art for details.

In order to ensure that the perovskite-crystalline silicon tandem solar cell 1 possesses relatively high efficiency during operation, the near-infrared luminescent material in this example usually has an absorption peak located in a range of 300 nm to 800 nm, and an emission peak located in a range of 800 nm to 1100 nm. That is, the near-infrared light conversion layer 2 adjusts a ratio of alight with a wavelength in a range of 300 nm to 800 nm and light with a wavelength in a range of 800 nm to 1100 nm.

It should be noted that, depending on different thicknesses of the near-infrared light conversion layer 2 or different materials used, an amount of absorbed short-wavelength light and an amount of emitted long-wavelength light will vary, and thus the adjustment of the ratio of short-wavelength light and long-wavelength light will also vary. However, obviously, the near-infrared light conversion layer 2 in this example does not absorb all short-wavelength light, for example, all light with a wavelength between 300 nm and 800 nm. It is obvious that compared with the perovskite-crystalline silicon tandem solar cell 1, the near-infrared light conversion layer 2 is easier to produce; therefore, the near-infrared light conversion layer 2 may be produced in a customized manner according to actual situations, thereby enabling the two-terminal perovskite-crystalline silicon tandem solar cell provided by this example to be more adaptable to light environments at different latitudes and in different scenarios.

In this example, the near-infrared light conversion layer 2 is usually detachably connected to the surface of the transparent cover plate 13 facing away from the back plate 12. A detachable connection facilitates replacement of the near-infrared light conversion layer 2, thereby enabling the two-terminal perovskite-crystalline silicon tandem solar cell provided by this example to have a broader scope of applicable environments. Specifically, the near-infrared light conversion layer 2 may be adhered to the surface of the transparent cover plate 13 facing away from the back plate 12, thereby facilitating installation and replacement of the near-infrared light conversion layer 2. In an actual scenario, after a usage environment of the two-terminal perovskite-crystalline silicon tandem solar cell is determined, it is only necessary to adhere a corresponding near-infrared conversion layer onto the surface of a manufactured perovskite-crystalline silicon tandem solar cell 1.

The two-terminal perovskite-silicon tandem solar cell provided by this example, by the provision with near-infrared light conversion layer 2, converts short wavelengths in sunlight into long wavelengths, respectively corresponding to absorptionby the perovskite top cell and by the crystalline silicon bottom cell, so as to solve the problem of current mismatch caused by a two-terminal perovskite-crystalline silicon tandem solar cell optimized based on AM1.5 standard sunlight being under illumination where a proportion of visible light is higher than that of AM1.5 standard sunlight, enabling the two-terminal perovskite-crystalline silicon tandem solar cell to still possess relatively high performance under non-AM1.5 standard sunlight conditions.

A method for producing a two-terminal perovskite-crystalline silicon tandem solar cell provided by an example of the present disclosure is described below. The method for producing a two-terminal perovskite-crystalline silicon tandem solar cell described below and the perovskite thin film described above may be referred to each other.

See FIG. 2, which is a process flow chart of a method for producing a two-terminal perovskite-crystalline silicon tandem solar cell provided by an example of the present disclosure.

As shown in FIG. 2, in the example of the present disclosure, the method for producing a two-terminal perovskite-crystalline silicon tandem solar cell comprises:
S101: Producing a near-infrared light conversion layer.

In the example of the present disclosure, the near-infrared light conversion layer 2 is a down-conversion film. In this example, the near-infrared conversion layer may be produced by a corresponding method depending on different structures of the near-infrared conversion layer. Specifically, this step usually comprises: producing a near-infrared luminescent material; wherein the near-infrared luminescent material is a down-conversion luminescent material; adding the near-infrared luminescent material into a polymer melt to produce a wet film; and curing the wet film to produce the near-infrared light conversion layer 2.

The above-mentioned near-infrared luminescent material may specifically be a near-infrared quantum-dot material or a near-infrared phosphor material. In this example, a corresponding method is used for production according to different types of near-infrared luminescent materials. Afterward, in this step, the near-infrared luminescent material is added to a polymer melt in a viscous flow state for dispersion, and then processed to produce a wet film. Thereafter, the wet film is cured and the solvent therein is evaporated to dryness, to produce the near-infrared light conversion layer 2.

S102: Producing a perovskite-crystalline silicon tandem solar cell.

In the example of the present disclosure, the perovskite-crystalline silicon tandem solar cell 1 comprises a tandem solar cell sheet 11, the tandem solar cell sheet 11 comprises a perovskite solar cell structure for absorbing visible light and a crystalline silicon solar cell structure for absorbing near-infrared light, and the perovskite solar cell structure and the crystalline silicon solar cell structure are current-matched based on AM1.5 standard sunlight. The structure of the perovskite-crystalline silicon tandem solar cell 1 is described in detail in the above-mentioned examples of the present disclosure, and specific content of this step is detailed in the following examples of the present disclosure.

It should be noted that there is no clear chronological order between the above S101 and S102, and they may be performed sequentially in any order or simultaneously.

S103: Providing the near-infrared light conversion layer on a surface of light-incident side of the perovskite-crystalline silicon tandem solar cell to produce a two-terminal perovskite-crystalline silicon tandem solar cell.

In this step, specifically, the near-infrared light conversion layer 2 may be adhered to the surface of light-incident side of the perovskite-crystalline silicon tandem solar cell 1 to produce the above-mentioned two-terminal perovskite-crystalline silicon tandem solar cell.

The method for producing a two-terminal perovskite-crystalline silicon tandem solar cell provided by the example of the present disclosure, by providing the near-infrared light conversion layer 2, converts short wavelengths in sunlight into long wavelengths, respectively corresponding to absorption by the perovskite top cell and by the crystalline silicon bottom cell, so as to solve the problem of current mismatch caused by a two-terminal perovskite-crystalline silicon tandem solar cell optimized based on AM1.5 standard sunlight being under illumination where a proportion of visible light is higher than that of AM1.5 standard sunlight, enabling the two-terminal perovskite-crystalline silicon tandem solar cell to still possess relatively high performance under non-AM1.5 standard sunlight conditions.

A method for producing a perovskite-crystalline silicon tandem solar cell 1 provided by an example of the present disclosure is described below.

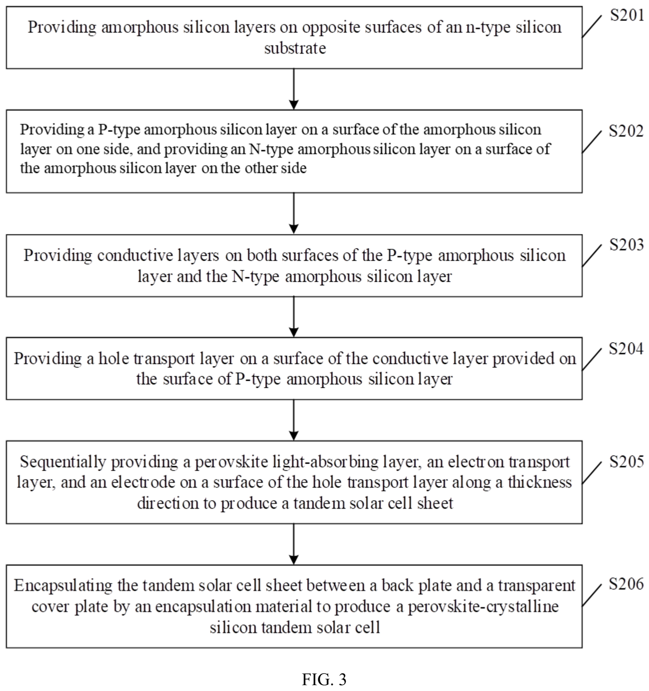

See FIG. 3, which is a process flow chart of a method for producing a perovskite-crystalline silicon tandem solar cell provided by an example of the present disclosure.

It should be noted that the following method for producing a perovskite-crystalline silicon tandem solar cell 1 corresponds to the specific content of the above S102. As shown in FIG. 3, in the example of the present disclosure, the method for producing a perovskite-crystalline silicon tandem solar cell 1 comprises:
S201: Providing amorphous silicon layers on opposite surfaces of an N-type silicon substrate.

In this step, specifically, an N-type silicon substrate is used, and then an amorphous silicon layer is provided on each of the opposite surfaces of the N-type silicon substrate by a process such as plasma-enhanced chemical vapor deposition, so that a total of two amorphous silicon layers are provided.

S202: Providing a P-type amorphous silicon layer on a surface of the amorphous silicon layer on one side, and providing an N-type amorphous silicon layer on a surface of the amorphous silicon layer on the other side.

In this step, a P-type amorphous silicon layer is provided on a surface of one of the two amorphous silicon layers, and an N-type amorphous silicon layer is provided on a surface of the other amorphous silicon layer.

S203: Providing conductive layers on both surfaces of the P-type amorphous silicon layer and the N-type amorphous silicon layer.

In this step, a conductive layer is provided on the surface of the P-type amorphous silicon layer, and a conductive layer is provided on the surface of the N-type amorphous silicon layer, respectively, so that a total of two conductive layers are provided to form a crystalline silicon solar cell structure. The conductive layer may be an ITO film or other conductive films, which is not specifically limited herein.

S204: Providing a hole transport layer on a surface of the conductive layer provided on the surface of the P-type amorphous silicon layer.

In this step, specifically, a hole transport layer may be provided on the surface of the conductive layer through a process such as magnetron sputtering, so as to subsequently form the perovskite solar cell structure.

S205: Sequentially providing a perovskite light-absorbing layer, an electron transport layer, and an electrode on a surface of the hole transport layer along a thickness direction to produce a tandem solar cell sheet.

In this step, the above-mentioned perovskite light-absorbing layer, electron transport layer, and electrode may be sequentially provided through methods such as deposition and/or vacuum evaporation to form the perovskite solar cell structure. Production processes of the respective film layers need to correspond to components thereof, and specific contents of the respective processes depend on actual situations and are not specifically limited herein.

After this step, an anti-reflection layer and/or a passivation layer may be further provided on the tandem solar cell sheet 11 to improve performance of the tandem solar cell sheet 11.

S206: Encapsulating the tandem solar cell sheet between a back plate and a transparent cover plate by an encapsulation material to produce a perovskite-crystalline silicon tandem solar cell.

In this step, the tandem solar cell sheet 11 needs to be encapsulated by an encapsulation material 14, a back plate 12, and a transparent cover plate 13 to produce the encapsulated perovskite-crystalline silicon tandem solar cell 1.

### Example 1

This example specifically provides a method for producing a two-terminal perovskite-crystalline silicon tandem solar cell using a near-infrared light conversion film based on CuInS₂/ZnS quantum dots.

Step 1: Producing quantum dots: A method for producing the quantum dots may refer to reported literature (Doctor-blade deposition of quantum dots onto standard window glass for low-loss large-area luminescent solar concentrators, Nature Energy, 1, 16157 (2016)). Specific steps are as follows:

Preparation of a zinc precursor: 440 mg of Zn(Ac)₂•2H₂O was taken and added to 3 mL of an OA (oleic acid) solution and 2 mL of an ODE (octadecene) solution, and the mixture was heated to 150°C and maintained for at least 30 min.

Preparation of CuInS₂ quantum dots: 76.2 mg of CuI, 247.8 mg of InI₃, and 35.2 mg of S were taken and added to a 50 mL three-necked flask; then 10 mL of ODE, 3 mL of DTT (dodecanethiol), 1 mL of OA, and 1 mL of OLA (oleylamine) were sequentially added; the mixture was heated to 100°C and continuously stirred until all solids were completely dissolved; during stirring, vacuum degassing was performed and maintained for 15 min, and the solution appeared red to dark red. Under nitrogen protection, the reaction temperature was increased to 220°C (10°C/min) and maintained at this temperature for 0 to 30 min to obtain CuInS₂ quantum dots of different sizes.

Preparation of CuInS₂/ZnS quantum dots: 5 mL of a solution of the zinc precursor was added at a rate of 1 to 2 mL/min to the above reaction system at 220°C; after the addition was completed, the temperature was adjusted to 250°C; after the reaction was performed for 45 min, the heat source was carefully removed to allow the reaction system to naturally cool to room temperature.

Purification of CuInS₂/ZnS quantum dots: Four times the volume of ethanol was added to the above cooled reaction solution; and the mixture was shaken evenly, and centrifuged at a speed of 8000 rpm for 5 min. After the centrifugation was completed, the supernatant was discarded, a black precipitate was redissolved with 20 mL of toluene, and two times the volume of ethanol was added again. The above operation was repeated three times.

Silicone was added to the prepared solution of CuInS₂/ZnS quantum dots in toluene, with a mass ratio of the quantum dots to the silicone being 2%. Then, a wet film was produced by screen printing, the solvent was evaporated to dryness, and curing was performed at 80°C for half an hour, to obtain a film with a thickness of 0.5 microns, which was the near-infrared light conversion layer 2.

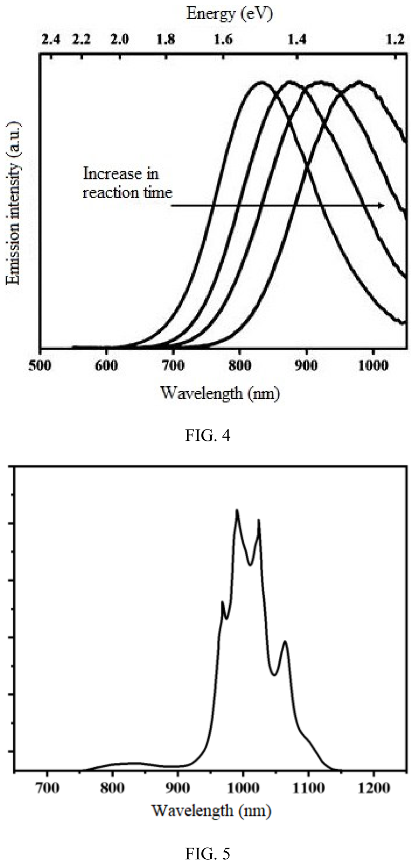

See FIG. 4, which is an emission spectrum diagram of CuInS₂/ZnS quantum-dot light conversion films produced based on different reaction times. By changing a nucleation reaction time from 0 min to 10 min, 20 min, and 30 min, near-infrared light conversion layers 2 with emission peaks at 833 nm, 876 nm, 921 nm, and 978 nm were obtained, with emission efficiencies of 92%, 91%, 89%, and 85%, respectively. According to characteristics of quantum dots, reaction conditions may be changed to change sizes of the quantum dots, thereby obtaining quantum-dot materials with different wavelengths. In this example, the near-infrared light conversion film may be produced based on quantum dots with an emission peak value of 978 nm.

Step 2: Producing a perovskite-crystalline silicon tandem solar cell 1.

An amorphous silicon layer was deposited on each of the cleaned and textured N-type monocrystalline silicon (C-Si) surfaces by a plasma-enhanced chemical vapor deposition process, with thicknesses of 10 nm (i-a-Si) and 8 nm (i-a-Si), respectively.

A 15 nm layer of P-type amorphous silicon (P-a-Si) was deposited on the 10 nm i-a-Si layer, and a 10 nm layer of N-type amorphous silicon (N-a-Si) was deposited on the 8 nm i-a-Si layer.

Two layers of indium tin oxide (ITO) were respectively prepared on the P-a-Si and the N-a-Si by magnetron sputtering, both with a thickness of 25 nm.

A layer of nickel oxide (NiOₓ) was sputtered as a hole transport layer on the ITO side of the N-type amorphous silicon (N-a-Si) by magnetron sputtering, with a thickness of 15 nm.

A perovskite light-absorbing layer was deposited on the NiOx. The deposition process of the perovskite light-absorbing layer was as follows: 2.8 mmol of cesium iodide (CsI), 11.2 mmol of formamidinium iodide (FAI), 0.07 mmol of phenethylammonium iodide, 5.6 mmol of lead iodide (PbI₂), and 8.4 mmol of lead bromide (PbBr₂) were weighed and mixed; 8 mL of N,N'-dimethylformamide (DMF) and 2 mL of dimethyl sulfoxide (DMSO) were added to the mixture; the mixture was fully stirred to be completely dissolved and filtered to form a precursor solution. A perovskite thin film of about 400 nm was produced by a solution method as the perovskite light-absorbing layer.

About 25 nm of fullerene (C60) and about 8 nm of 2,9-dimethyl-4,7-diphenyl-1,10-phenanthroline (BCP) were deposited on the perovskite layer by vacuum evaporation as an electron transport layer. Afterward, 800 nm of silver was deposited on the electron transport layer by vacuum evaporation as an electrode, wherein patterning using a mask plate was required. Then, a layer of 85 nm magnesium fluoride was provided by evaporation at a position coated with perovskite but not deposited with the silver electrode as an anti-reflection layer, so as to obtain a tandem solar cell sheet 11.

The tandem solar cell sheet 11 may adopt a double-glass encapsulation method same as that for crystalline silicon solar cells. A back plate 12 and a transparent cover plate 13 were glass for double-glass encapsulation, and an encapsulation material 14 was polyolefin elastomer and butyl rubber. The back plate 12 and the transparent cover plate 13 sandwiched the tandem solar cell sheet therebetween, and the encapsulation material 14 was used for bonding the two pieces of glass. Other opaque substrate materials may also be used for the back plate 12. Thus, the perovskite-crystalline silicon tandem solar cell 1 was obtained. Factors such as bandgap and thickness of the tandem solar cell sheet 11 in the perovskite-crystalline silicon tandem solar cell 1 were all optimized based on AM1.5 standard light testing. Through testing, current densities of the top cell and the bottom cell were obtained as 19.2 mAcm⁻² and 19.4 mAcm⁻², respectively, indicating that the cell achieved current match under AM1.5 standard light.

Step 3: The obtained near-infrared light conversion layer 2 was placed flat on a light-incident surface of the encapsulated perovskite-crystalline silicon tandem solar cell 1, i.e., placed on top of the front cover plate, to obtain the above-mentioned two-terminal perovskite-crystalline silicon tandem solar cell having the near-infrared light conversion layer 2.

### Example 2

This example specifically provides a method for producing a two-terminal perovskite-crystalline silicon tandem solar cell using a near-infrared light conversion film based on near-infrared phosphors.

Step 1: First, near-infrared phosphors were prepared as follows:

Lu₂O₃, Sc₂O₃, H₃BO₃, Cr₂O₃, and Yb₂O₃ were weighed according to a molar ratio of 20:80:255:2:5, and mixed uniformly by ball milling. The mixture was calcined at 1200°C. After crushing, sieving, and washing, the near-infrared phosphors were obtained.

The prepared Lu_{0.2}Sc_{0.8}BO₃, 2%Cr³⁺ and 5%Yb³⁺ were directly added to a solution of silicone in n-hexane and dispersed by ultrasound, with a mass ratio of the phosphor to the silicone being 1%; then, a wet film was produced by a screen printing method, the solvent was evaporated to dryness, and curing was performed at 80°C for half an hour to obtain a film with a thickness of 1 micron, which was the near-infrared light conversion layer 2.

See FIG. 5, which is an emission spectrum diagram of the near-infrared light conversion layer 2. As shown in FIG. 5, similar to the quantum-dot-based near-infrared light conversion film, conversion of visible light into near-infrared light was also realized.

Step 2: Next, a two-terminal tandem solar cell was produced. The process steps were the same as those in Example 1, specifically as follows:

An amorphous silicon layer was deposited on each of the cleaned and textured N-type monocrystalline silicon (C-Si) surfaces by a plasma-enhanced chemical vapor deposition process, with thicknesses of 10 nm (i-a-Si) and 8 nm (i-a-Si), respectively.

A 15 nm layer of P-type amorphous silicon (P-a-Si) was deposited on the 10 nm i-a-Si, and a 10 nm layer of N-type amorphous silicon (N-a-Si) was deposited on the 8 nm i-a-Si.

Two layers of indium tin oxide (ITO) were respectively prepared on the P-a-Si and the N-a-Si by magnetron sputtering, both with a thickness of 25 nm.

A layer of nickel oxide (NiOₓ) was sputtered as a hole transport layer on the ITO side by magnetron sputtering, with a thickness of 15 nm.

A perovskite light-absorbing layer was deposited on the NiOx. The deposition process of the perovskite light-absorbing layer was as follows: 2.8 mmol of cesium iodide (CsI), 11.2 mmol of formamidinium iodide (FAI), 0.07 mmol of phenethylammonium iodide, 5.6 mmol of lead iodide (PbI₂), and 8.4 mmol of lead bromide (PbBr₂) were weighed and mixed; 8 mL of N,N'-dimethylformamide (DMF) and 2 mL of dimethyl sulfoxide (DMSO) were added to the mixture and fully stirred to be completely dissolved and the mixture was filtered to form a precursor solution. A perovskite thin film of about 400 nm was produced by a solution method as the perovskite light-absorbing layer.

About 25 nm of fullerene (C60) and about 8 nm of 2,9-dimethyl-4,7-diphenyl-1,10-phenanthroline (BCP) were deposited on the perovskite layer by vacuum evaporation as an electron transport layer. Afterward, 800 nm of silver was deposited on the electron transport layer by vacuum evaporation as an electrode, wherein patterning using a mask plate was required. Then, a layer of 85 nm magnesium fluoride was provided by evaporation at a position coated with perovskite but not deposited with the silver electrode as an anti-reflection layer, so as to obtain a tandem solar cell sheet 11.

The tandem solar cell sheet 11 may adopt a double-glass encapsulation method same as that for crystalline silicon solar cells. A back plate 12 and a transparent cover plate 13 were glass for double-glass encapsulation, and an encapsulation material 14 was polyolefin elastomer and butyl rubber. The back plate 12 and the transparent cover plate 13 sandwiched the tandem solar cell sheet therebetween, and the encapsulation material 14 was used for bonding the two pieces of glass. Other opaque substrate materials may also be used for the back plate 12. Thus, the perovskite-crystalline silicon tandem solar cell 1 was obtained. Factors such as bandgap and thickness of the tandem solar cell sheet 11 in the perovskite-crystalline silicon tandem solar cell 1 were all optimized based on AM1.5 standard light testing. Through testing, current densities of the top cell and the bottom cell were obtained as 19.2 mAcm⁻² and 19.4 mAcm⁻², respectively, indicating that the cell achieved current match under AM1.5 standard light.

Step 3: The near-infrared light conversion layer 2 produced based on near-infrared phosphors was placed flat on a light-incident surface of the encapsulated perovskite-crystalline silicon tandem solar cell 1, i.e., placed on top of the front cover plate, to obtain the two-terminal perovskite-crystalline silicon tandem solar cell having the near-infrared light conversion layer 2 of Example 2.

### Comparative Example 1

This comparative example differed from Example 1 in that, no production of the near-infrared light conversion layer 2 was performed, and no near-infrared light conversion layer 2 was provided on the surface of the encapsulated perovskite-crystalline silicon tandem solar cell 1. Thus, the two-terminal perovskite-crystalline silicon tandem solar cell of Comparative Example 1 having no near-infrared light conversion layer 2 was obtained.

### Test Methods

In order to characterize current matching conditions of the two-terminal tandem solar cell, a current-voltage test with a tunable light source spectrum (Spectrometric Characterization of Monolithic Perovskite/Silicon Tandem Solar Cells, Sol. RRL 2023, 7, 2200948) was adopted in the present disclosure. The specific principle was to test current-voltage curves of the two-terminal tandem solar cell under different spectra by changing a solar spectrum simulator based on a light-emitting diode. For a two-terminal perovskite-crystalline silicon tandem solar cell 1 optimized based on AM1.5, when a spectrum of the test light source approached AM1.5, currents of two sub-cell structures were close, and a maximum current of the two-terminal tandem solar cell was achieved. When a proportion of visible light of the test light source increased, that is, the spectrum blue-shifted (by increasing power of visible light-emitting diodes and decreasing power of near-infrared light-emitting diodes in the solar simulator), a photocurrent generated by the crystalline silicon sub-cell decreased, but a photocurrent generated by the perovskite sub-cell increased; since this was a tandem battery, the current of the two-terminal tandem solar cell eventually decreased as well. Therefore, when the spectrum blue-shifted, the current of the crystalline silicon sub-cell would limit the current of the device. Conversely, when the spectrum red-shifted, the current of the perovskite sub-cell would limit the current of the device.

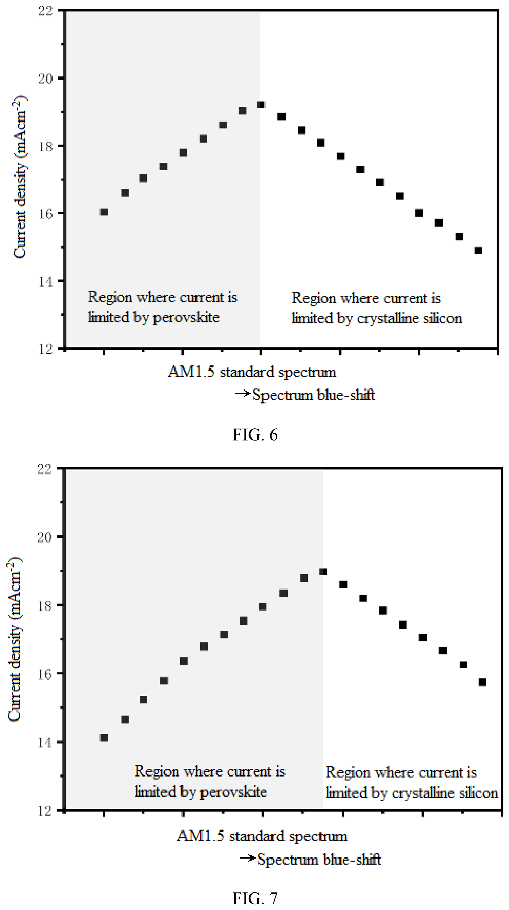

See FIG. 6, which is a diagram showing changes in current of the two-terminal perovskite-crystalline silicon tandem solar cell 1 optimized based on AM1.5 standard sunlight in Comparative Example 1 as the test spectrum changes. As shown in FIG. 6, the spectrum corresponding to the maximum current value therein was the AM1.5 standard spectrum. When the test spectrum blue-shifted, the current of the two-terminal perovskite-crystalline silicon tandem solar cell 1 optimized based on AM1.5 decreased.

See FIG. 7, which is a diagram showing changes in current of the two-terminal perovskite-crystalline silicon tandem solar cell 1 containing the near-infrared light conversion layer 2 in Example 1 as the test spectrum changes. As shown in FIG. 7, the spectrum corresponding to the maximum current value, that is, a matched current of the two sub-cell structures, blue-shifted compared with the AM1.5 standard spectrum. The Example 1 only differred from Comparative Example 1 in the provision of a near-infrared light conversion layer 2, which can achieve current match under different spectra without changing a bandgap, film thickness, and structure of the perovskite.

In the present disclosure, performances of the two-terminal perovskite-crystalline silicon tandem solar cells 1 in Comparative Example 1 and Example 1 were tested under a non-AM1.5 standard solar spectrum. Total power of the multi-channel LED (light-emitting diode) light source simulator was controlled to remain at 1000 W/m²; optical power of a wavelength band less than 800 nm was increased by 5%, and optical power of a wavelength band greater than 800 nm was decreased by 5%. The current of the tandem solar cell of Comparative Example 1 decreased to 17.8 mA/cm², and energy conversion efficiency was 28.9%. In contrast, the current of the tandem solar cell of Example 1 was 18.9 mA/cm², and energy conversion efficiency was 30.1%. This result indicated that the two-terminal perovskite-crystalline silicon tandem solar cell 1 containing the near-infrared light conversion layer 2 significantly improved the efficiency of the two-terminal perovskite-crystalline silicon tandem solar cell 1 under a non-AM1.5 standard solar spectrum (with a large proportion of visible light).

Next, performances of the two-terminal perovskite-crystalline silicon tandem solar cells 1 in Comparative Example 1 and Example 2 were tested under a non-AM1.5 standard solar spectrum. The total power of the multi-channel LED light source simulator was controlled to remain at 1000 W/m²; optical power of a wavelength band less than 800 nm was increased by 5%, and optical power of a wavelength band greater than 800 nm was decreased by 5%. The current of the tandem solar cell of Comparative Example 1 decreased to 17.8 mA/cm², and energy conversion efficiency was 28.9%. In contrast, the current of the tandem solar cell of Example 1 was 18.4 mA/cm², and energy conversion efficiency was 29.4%. This result indicated that the near-infrared light conversion layer 2 produced based on the near-infrared phosphor also improved the efficiency of the two-terminal perovskite-crystalline silicon tandem solar cell 1 under a non-AM1.5 standard solar spectrum.

Various examples in this specification are described in a progressive manner, each example focuses on differences from other examples, and identical or similar parts between various examples may be referred to each other.

Those of ordinary skill in the art can further realize that units and algorithm steps of various examples described in conjunction with the examples disclosed herein can be implemented by electronic hardware, computer software, or a combination of both. To clearly illustrate interchangeability of hardware and software, compositions and steps of various examples have been generally described in terms of functions in the above description. Whether these functions are executed by hardware or software depends on specific applications and design constraints of the technical solution. Those of ordinary skill in the art can use different methods to implement the described functions for each specific application, but such implementation should not be considered as going beyond the scope of the present disclosure.

Steps of methods or algorithms described in conjunction with the examples disclosed herein can be implemented directly by hardware, software modules executed by a processor, or a combination of both. The software modules can be placed in a random access memory (RAM), a memory, a read-only memory (ROM), an electrically programmable ROM, an electrically erasable programmable ROM, a register, a hard disk, a removable disk, a CD-ROM, or any other form of storage medium known in the art.

Finally, it should also be noted that, herein, relational terms such as first and second are only used to distinguish one entity or operation from another entity or operation, without necessarily requiring or implying existence of any such actual relationship or order between these entities or operations. Furthermore, the terms "comprise", "include", or any other variants thereof, are intended to encompass non-exclusive inclusion, so that a process, method, article, or device comprising a series of elements not only comprises those elements, but also comprises other elements not explicitly listed, or further comprises elements inherent to such process, method, article, or device. Without further limitation, an element defined by the phrase "comprising a ..." does not exclude the presence of other identical elements in the process, method, article, or device comprising said element.

The two-terminal perovskite-crystalline silicon tandem solar cell and the production method thereof provided by the present disclosure have been described in detail above. Specific examples are used herein to explain the principles and implementations of the present disclosure, and the descriptions of the above examples are only used to help understand the method and the core idea of the present disclosure. It should be pointed out that for those of ordinary skill in the art, without departing from the principles of the present disclosure, several improvements and modifications can be made to the present disclosure, and these improvements and modifications also fall within the protection scope of the claims of the present disclosure.

## Claims

1. A two-terminal perovskite-crystalline silicon tandem solar cell, comprising a perovskite-crystalline silicon tandem solar cell and a near-infrared light conversion layer; wherein:
the perovskite-crystalline silicon tandem solar cell comprises a tandem solar cell sheet, and the tandem solar cell sheet comprises a perovskite solar cell structure for absorbing visible light and a crystalline silicon solar cell structure for absorbing near-infrared light;
the near-infrared light conversion layer is provided on a surface of light-incident side of the perovskite-crystalline silicon tandem solar cell, and the near-infrared light conversion layer is a down-conversion film.

2. The two-terminal perovskite-crystalline silicon tandem solar cell according to claim 1, wherein the perovskite-crystalline silicon tandem solar cell comprises a back plate and a transparent cover plate disposed opposite to each other, the tandem solar cell sheet is encapsulated between the back plate and the transparent cover plate by an encapsulation material, and the near-infrared light conversion layer is provided on a surface of the transparent cover plate facing away from the back plate.

3. The two-terminal perovskite-crystalline silicon tandem solar cell according to claim 2, wherein the near-infrared light conversion layer is detachably connected to the surface of the transparent cover plate facing away from the back plate.

4. The two-terminal perovskite-crystalline silicon tandem solar cell according to claim 1, wherein the near-infrared light conversion layer comprises a polymer matrix and a near-infrared luminescent material dispersed in the polymer matrix; and the near-infrared luminescent material is a down-conversion luminescent material.

5. The two-terminal perovskite-crystalline silicon tandem solar cell according to claim 4, wherein the near-infrared luminescent material comprises any one or a combination of:
a near-infrared quantum-dot material and a near-infrared phosphor material.

6. The two-terminal perovskite-crystalline silicon tandem solar cell according to claim 4, wherein the near-infrared luminescent material has an absorption peak located in a range of 300 nm to 800 nm, and an emission peak located in a range of 800 nm to 1100 nm.

7. The two-terminal perovskite-crystalline silicon tandem solar cell according to claim 4, wherein the polymer matrix is at least one selected from the group consisting of:
polyolefin elastomer, polymethyl methacrylate, polyvinylpyrrolidone, silicone, and acrylic resin.

8. A method for producing a two-terminal perovskite-crystalline silicon tandem solar cell, comprising:
producing a near-infrared light conversion layer; wherein the near-infrared light conversion layer is a down-conversion film;
producing a perovskite-crystalline silicon tandem solar cell; wherein the perovskite-crystalline silicon tandem solar cell comprises a tandem solar cell sheet, and the tandem solar cell sheet comprises a perovskite solar cell structure for absorbing visible light and a crystalline silicon solar cell structure for absorbing near-infrared light; and
providing the near-infrared light conversion layer on a surface of light-incident side of the perovskite-crystalline silicon tandem solar cell to produce the two-terminal perovskite-crystalline silicon tandem solar cell.

9. The method according to claim 8, wherein the producing a near-infrared light conversion layer comprises:
producing a near-infrared luminescent material; wherein the near-infrared luminescent material is a down-conversion luminescent material;
adding the near-infrared luminescent material into a polymer melt to produce a wet film; and
curing the wet film to produce the near-infrared light conversion layer.

10. The method according to claim 8, wherein the producing a perovskite-crystalline silicon tandem solar cell comprises:
providing amorphous silicon layers on opposite surfaces of an N-type silicon substrate;
providing a P-type amorphous silicon layer on a surface of the amorphous silicon layer on one side, and providing an N-type amorphous silicon layer on a surface of the amorphous silicon layer on the other side;
providing conductive layers on both surfaces of the P-type amorphous silicon layer and the N-type amorphous silicon layer;
providing a hole transport layer on a surface of the conductive layer provided on the surface of P-type amorphous silicon layer;
sequentially providing a perovskite light-absorbing layer, an electron transport layer, and an electrode on a surface of the hole transport layer along a thickness direction to produce the tandem solar cell sheet; and
encapsulating the tandem solar cell sheet between a back plate and a transparent cover plate by an encapsulation material to produce the perovskite-crystalline silicon tandem solar cell.
